Europäisches Patentamt

European Patent Office

Office européen des brevets

(19)

(11) Veröffentlichungsnummer: **0 113 852**
**A2**

(12) **EUROPÄISCHE PATENTANMELDUNG**

(21) Anmeldenummer: 83112267.6

(22) Anmeldetag: 06.12.83

(51) Int. Cl.³: **H 05 K 9/00**

(30) Priorität: 17.12.82 DE 3246900

(43) Veröffentlichungstag der Anmeldung: 25.07.84
**Patentblatt 84/30**

(84) Benannte Vertragsstaaten: **AT BE DE FR GB IT NL**

(71) Anmelder: **SIEMENS AKTIENGESELLSCHAFT, Berlin und München Wittelsbacherplatz 2, D-8000 München 2 (DE)**

(72) Erfinder: **Patscheck, Max, Konrad-Celtis-Strasse 65, D-8000 München 70 (DE)**
Erfinder: **Schmid, Rupert, Luitpoldstrasse 46, D-8900 Augsburg (DE)**

(54) **HF-dichte Verbindung von Rechnerschränken.**

(57)  Die Erfindung bezieht sich auf eine HF-dichte Verbindung von Rechnerschränken durch zwischen jeweils zwei benachbarten Schränken eingesetzte Kontaktleisten. Diese Kontaktleisten sollen vereinfacht werden. Dafür sieht die Erfindung vor, daß die Kontaktleisten (1) aus U-förmig gebogenen Stahlblechstreifen (2) bestehen, deren beide U-förmigen Schenkel (3) mit parallel zu den Schenkeln verlaufenden Schlitzen (4) versehen sind, wobei die zwischen den Schlitzen (4) befindlichen Schenkelteile (5) leicht nach außen abgewinkelt sind.

0113852

SIEMENS AKTIENGESELLSCHAFT
Berlin und München

Unser Zeichen

VPA 82 P 2079 E

## HF-dichte Verbindung von Rechnerschränken.

Die Erfindung betrifft eine HF-dichte Verbindung von Rechnerschränken durch zwischen jeweils zwei benachbarten Schränken eingesetzte Kontaktleisten.

Zur Abdichtung der Zwischenräume von Rechnerschränken werden bisher Kontaktstreifen verwendet, die auf einem Z-förmigen Blechstreifen aufgesteckte Kontaktfedern enthalten, wobei der Z-förmige Blechstreifen auf einem U-förmigen Blechstreifen, dessen einer Schenkel verlängert ist, befestigt ist. Dabei sind für eine abzudichtende Seite mehrere Teile notwendig, außerdem ist der mit Federn versehene Blechstreifen aufwendig in der Herstellung und in der Montage.

Aufgabe der vorliegenden Erfindung ist es, HF-dichte Verbindungen von Rechnerschränken zu schaffen, die ohne großen Fertigungsaufwand herzustellen und leicht montierbar sind.

Zur Lösung dieser Aufgabe wird die HF-dichte Verbindung von Rechnerschränken derart ausgebildet, daß die Kontaktleisten aus U-förmig gebogenen Stahlblechstreifen bestehen, deren beide U-förmigen Schenkel mit parallel zu den Schenkeln verlaufenden Schlitzen versehen sind, und daß die zwischen den Schlitzen befindlichen Schenkelteile leicht nach außen abgewinkelt sind.

Dadurch erhält man eine HF-Dichtung, die nur aus einem Teil besteht und sich leicht zu einem Rahmen zusammenfügen läßt. Zur Montage genügen nur wenige Schraubverbindungen.

Zk 1 Fdl/ 30. 11. 1982

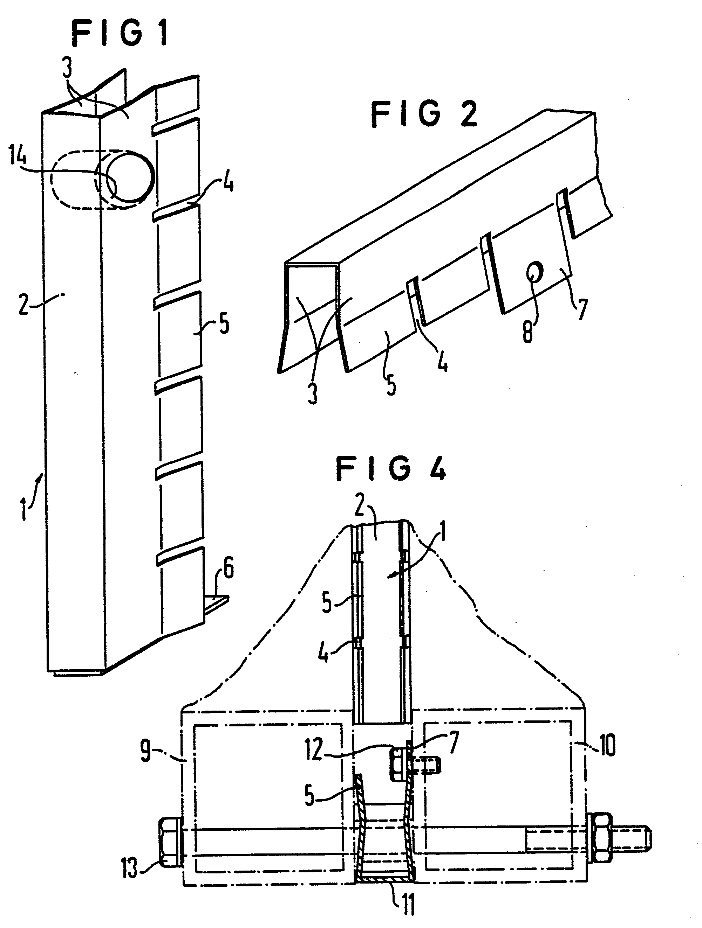

Anhand der Ausführungsbeispiele nach den Figuren 1 bis
4 wird die Erfindung näher erläutert. Es zeigen:
Fig. 1 einen Kontaktstreifen zum senkrechten Einbau,
Fig. 2 einen Kontaktstreifen für den waagerechten Einbau,
Fig. 3 einen aus den beiden Teilen nach Fig. 1 und 2
      zusammengefügten Einbaurahmen,
Fig. 4 den Schnitt I...I in Fig. 3.

Die Kontaktleiste 1 für den vertikalen Einbau besteht im
wesentlichen aus einem U-förmig gebogenen Stahlblechstreifen 2, der im vorgegebenen Abstand in seinen Schenkeln 3 durch gestanzte Schlitze 4 aufgefiedert ist. Die
zwischen den Schlitzen liegenden Schenkelteile 5 sind
dabei leicht nach außen gebogen. An der Unter- bzw.
Oberseite wird der U-förmige Streifen mit einem nach
innen stehenden Blech 6 abgeschlossen. Außerdem enthält
er mehrere rohrförmig ausgebildete Distanzstücke 14.
Diese Distanzstücke vermeiden ein zu starkes Zusammendrücken der Kontaktstreifen bei der Verschraubung der
Schränke untereinander.

Ein Streifen, der für den waagerechten Einbau gedacht
ist, ist in Fig. 2 gezeigt. Er ist im wesentlichen gleich
ausgebildet wie der Streifen nach Fig. 1. Es entfallen
lediglich die an beiden Enden vorgesehenen Abschlußstreifen 6. Außerdem zeigt Fig. 2 ein gegenüber den
übrigen geschlitzten Schenkelteilen verlängertes Schenkelteil 7, in dem sich eine Bohrung 8 zur Befestigung befindet.

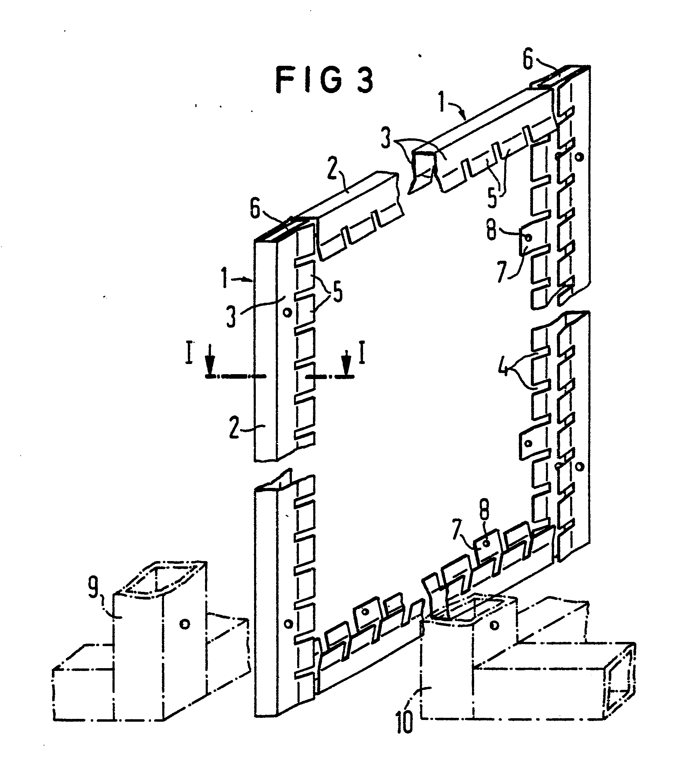

In Fig. 3 ist ein aus den beiden Grundelementen aufgebauter Rahmen dargestellt, wie er bei der Abdichtung
von Rechnerschränken zum Einsatz kommt. Links und rechts
neben dem Rahmen sind die Gerüstkonstruktionen 9 und 10
zweier Rechner angedeutet.

Einen Schnitt I...I durch die Anordnung nach Fig. 3 zeigt Fig. 4. Zwischen den Vertikalholmen 9 und 10 der Rechnergerüste liegt der HF-dichte Rahmen 11, der mit Schrauben 12 an den Rechnerwänden befestigt ist. Durch Zusammenschrauben der beiden Schrankgerüste mit den Schrauben 13 wird der aufgefiederte Teil der HF-dichten Rahmen 11 zusammengedrückt und kontaktiert so an beiden Gerüsten gleichzeitig.

4 FIGUREEN
1 Patentanspruch

0113852

VPA 82 P 2079 E

Patentanspruch

1. HF-dichte Verbindung von Rechnerschränken durch zwischen jeweils zwei benachbarten Schränken eingesetzte Kontaktleisten, d a d u r c h   g e k e n n z e i c h - n e t, daß die Kontaktleisten aus U-förmig gebogenen Stahlblechstreifen bestehen, deren beide U-förmigen Schenkel mit parallel zu den Schenkeln verlaufenden Schlitzen versehen sind, und daß die zwischen den Schlitzen befindlichen Schenkelteile leicht nach außen abgewinkelt sind.

0113852

1/2

FIG 1

FIG 2

FIG 4

FIG 3